(19) Europäisches Patentamt / European Patent Office / Office européen des brevets

(11) **EP 4 589 478 A1**

(12) **EUROPEAN PATENT APPLICATION**

(43) Date of publication:
23.07.2025 Bulletin 2025/30

(21) Application number: 25151502.9

(22) Date of filing: 13.01.2025

(51) International Patent Classification (IPC):
**G06N 3/065** (2023.01)   **G11C 11/54** (2006.01)
**H03M 1/00** (2006.01)

(52) Cooperative Patent Classification (CPC):
**G11C 11/54; G06N 3/065; H03M 1/1245;**
H03M 1/12

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **17.01.2024 FI 20245040**

(71) Applicant: **Nokia Solutions and Networks Oy
02610 Espoo (FI)**

(72) Inventors:
• JIANG, Zhewei
  **Oakland Gardens - NY (US)**
• CHOW, Hungkei
  **Murray Hill - NJ (US)**

(74) Representative: **Nokia EPO representatives
Nokia Technologies Oy
Karakaari 7
02610 Espoo (FI)**

(54) **COMPUTE-IN-MEMORY APPARATUS**

(57)    According to an example embodiment, an apparatus comprises a capacitor mesh circuit comprising a plurality of signal lines and a bitcell array comprising a plurality of bitcells.

FIG. 1

EP 4 589 478 A1

300

108

106

2C

4C

2C

C

C

2C

C

2C

C

2C

C

2C

C

C

306

$V_{mesh}$

308

304

FIG. 3A

**Description**

**TECHNICAL FIELD**

The present application generally relates to the field of computing. In particular, the present application relates to an apparatus.

**BACKGROUND**

In traditional computing systems, data is typically stored in memory that is separate from the processor which performs tasks such as arithmetic and logic functions. With the increase in data required for certain applications, such as machine learning, data movement between the processor and memory may present one of the more significant performance and energy bottlenecks. In-memory computing can improve processing performance through the use of memory technologies that are also able to perform certain computational tasks such as the arithmetic and/or logical functions.

**SUMMARY**

The scope of protection sought for various example embodiments is set out by the independent claims. The example embodiments and features, if any, described in this specification that do not fall under the scope of the independent claims are to be interpreted as examples useful for understanding various example embodiments.

An example embodiment of an apparatus comprise: a capacitor mesh circuit comprising a plurality of signal lines; and a bitcell array comprising a plurality of bitcells, wherein each bitcell of the bitcell array comprises a storage unit for storing a weight bit of a weight value and a multiplication unit configured to multiply the weight bit by an input bit of an input value and to provide a result of the multiplication to an output of the bitcell, and the output of each bitcell in a column of the bitcell array is coupled to corresponding signal line in the capacitor mesh circuit via at least one capacitor; wherein each signal line in the plurality of signal lines is electrically coupled such that the capacitor mesh circuit forms a binary-weighted capacitive voltage divider circuit between the plurality of signal lines; and a signal line coupled to the outputs of bitcells in a most significant weight bit, MSWB, column of the bitcell array comprises an output of the capacitor mesh circuit.

In an example embodiment, alternatively or in addition to the above-described example embodiments, the output of the capacitor mesh circuit is configured to provide a partial multiply-accumulate, MAC, result and the partial MAC result comprises, for each cycle of an input value, a sum of multiplications of the MSWB column and a binary-weighted sum of the multiplications of each non-MSWB column.

In an example embodiment, alternatively or in addition to the above-described example embodiments, each capacitor in the at least one capacitor comprises a first capacitor, each first capacitor having a target capacitance of an integer multiple of a unit capacitance; each signal line comprises a plurality of row positions in the capacitor mesh circuit, wherein each row position is coupled to at least one first capacitor; row positions in each signal line are electrically coupled to each other; and the integer multipliers between the row positions form a capacitive voltage division of the binary-weighted capacitive voltage divider.

In an example embodiment, alternatively or in addition to the above-described example embodiments, the integer multiplier for each first capacitor of the MSWB signal line is four; the integer multiplier for each first capacitor of a second most significant weight bit signal line is two; the integer multiplier for each first capacitor of a third most significant weight bit signal line is one; wherein the MSWB signal line, the second most significant weight bit signal line and the third most significant weight bit signal line are coupled to each other with a short circuit and wherein: each signal line of lesser significance than the second most significant weight bit signal line is coupled to a signal line of one higher bit significance through at least one second capacitor, each second capacitor having a target capacitance of two times the unit capacitance; and each first capacitor of a signal line of lesser bit significance than the second most significant weight bit signal line has an integer multiplier of one; and a signal line of a least significant bit, LSB, is coupled to ground with at least one third capacitor, each third capacitor having a target capacitance equal to the unit capacitance.

In an example embodiment, alternatively or in addition to the above-described example embodiments, the multiplication unit of each bitcell in a column in the bitcell array representing a non-most significant bit, non-MSB, of a weight value is an AND gate; the multiplication unit of each bitcell in a column in the bitcell array representing a most significant bit, MSB, of a weight value is a NAND gate.

In an example embodiment, alternatively or in addition to the above-described example embodiments, the apparatus further comprises: a sample-and-hold circuit comprising at least one holding capacitor, the at least one holding capacitor electrically couplable to sample a voltage at the output of the capacitor mesh circuit.

In an example embodiment, alternatively or in addition to the above-described example embodiments, the sample-and-hold circuit comprises a first holding capacitor and a second holding capacitor, the first holding capacitor and the second holding capacitor being electrically couplable to the output of the capacitor mesh circuit to sample the voltage at the output of the capacitor mesh circuit for each cycle of an input value of size N to obtain an analog MAC result.

In an example embodiment, alternatively or in addition to the above-described example embodiments, the sample-and-hold circuit further comprises: a first coupling switch electrically coupled between the first holding capacitor and the output of the capacitor mesh circuit; a second coupling switch electrically coupled between the second holding capacitor and the output of the capacitor mesh circuit; a first reset switch electrically coupled between the first holding capacitor and ground; a second reset switch electrically coupled between the second holding capacitor and ground; and a mesh reset switch electrically coupled between the output of the capacitor mesh circuit and ground; wherein the apparatus further comprises a sample and-hold control, SHCTRL, circuit configured to control the first coupling switch, the second coupling switch, the first reset switch, the second reset switch, and the mesh reset switch to obtain the analog MAC result.

In an example embodiment, alternatively or in addition to the above-described example embodiments, the apparatus further comprises an analog-to-digital converter, ADC, circuit, wherein the ADC circuit is configured to convert the analog MAC result to a digital MAC result, and the sample-and-hold circuit further comprises: a first output switch electrically coupled between the first holding capacitor and the ADC circuit; and a second output switch electrically coupled between the second holding capacitor and the ADC circuit; wherein the SHCTRL circuit is further configured to control the first output switch and the second output switch to connect the first holding capacitor and the second holding capacitor the ADC circuit in an alternating fashion.

In an example embodiment, alternatively or in addition to the above-described example embodiments, the SHCTRL circuit is further configured to, by controlling the first coupling switch, the second coupling switch, the first reset switch, the second reset switch, the mesh reset switch, the first output switch, and the second output switch, to: accumulate partial MAC results over a first plurality of input cycles to the first holding capacitor as a first analog MAC result; accumulate partial MAC results over a second plurality of input cycles to the second holding capacitor as a second analog MAC result; and during the second plurality of input cycles, provide the first MAC result to the ADC circuit.

In an example embodiment, alternatively or in addition to the above-described example embodiments, the apparatus further comprises a MAC Write Line, MACWL, decoder circuit, wherein the MACWL decoder circuit is configured to serially send input bits of the input value to the bitcell array to be multiplied by the weight value.

In an example embodiment, alternatively or in addition to the above-described example embodiments, the apparatus further comprises: an address decoder circuit configured obtain and address and to set a bitcell corresponding to the address to a Read and Write state; and a Read and Write, R/W, -circuit, configured to set or reset storage units of the bitcell corresponding to the address.

An example embodiment of a method comprises: receiving at least one weight value comprising M weight bits; storing each weight value in the at least one weight value on a row of the bitcell array, wherein the weight value is distributed across M adjacent columns of bitcells as weight bits; receiving an input value comprising N input bits; computing an analog multiply-accumulate, MAC, result representing summed products of the input value and the at least one weight value, wherein the computing the analog MAC result comprises: for each of N input cycles: multiplying an input bit of the input value by each weight bit of the weight value stored in the bitcell array; summing a result of the multiplications of each weight bit position to a column position in a binary-weighted capacitive voltage divider circuit thus obtaining a partial MAC result at a most significant weight bit, MSWB, column position of the binary-weighted capacitive voltage divider circuit, wherein the partial MAC result comprises a sum of result of the multiplications of the MSWB column position and a binary-weighted sum of result of the multiplications of each non-MSWB column position; and storing the partial MAC result to at least one holding capacitor of a sample-and-hold circuit; and obtaining the analog MAC result based on the partial MAC results over the N input cycle.

In an example embodiment, alternatively or in addition to the above-described example embodiments, the computing the analog MAC result further comprises: accumulating the partial MAC results over a first plurality of N input cycles to a first holding capacitor as a first analog MAC result; and accumulating the partial MAC results over a second plurality of N input cycles to a second holding capacitor as a second analog MAC result and, during the second plurality of N input cycles, providing the first MAC result to an ADC.

An example embodiment of a compute in memory, CIM, device comprises at least one CIM module, wherein each CIM module in the at least one CIM module comprises the apparatus of any of the above-described example embodiments, and the CIM device further comprises a controller configured to perform the method of any of the above-described example embodiments using the at least one CIM module.

An example embodiment of a computer program product comprises program code configured to perform the method according to any of the above example embodiments when the computer program product is executed on a computer.

## DESCRIPTION OF THE DRAWINGS

The accompanying drawings, which are included to provide a further understanding of the example embodiments and constitute a part of this specification, illustrate example embodiments and together with the description help to explain the principles of the example embodiments. In the drawings:

Fig. 1 illustrates an example embodiment of an apparatus;
Fig. 2A illustrates an example embodiment of a bitcell;
Fig. 2B illustrates another example embodiment of a bitcell;
Fig. 3A illustrates an example embodiment of a capacitor mesh circuit;
Fig. 3B illustrates another example embodiment of a capacitor mesh circuit;
Fig. 4 illustrates effect of two four-bit weight values adding to a row instance of a capacitor mesh circuit according to an example embodiment;
Fig. 5 illustrates an example embodiment of a sample and hold circuit;
Fig. 6 illustrates an example embodiment of a sample and hold procedure;
Fig. 7 illustrates a compute-in-memory, CIM, device according to an example embodiment;
Fig. 8 illustrates a compute-in-memory, CIM, device according to an example embodiment;
Fig. 9 illustrates an example embodiment of a method; and
Fig. 10 illustrates another example embodiment of a method.

Like reference numerals are used to designate like parts in the accompanying drawings.

**DETAILED DESCRIPTION**

Reference will now be made in detail to example embodiments, examples of which are illustrated in the accompanying drawings. The detailed description provided below in connection with the appended drawings is intended as a description of the present examples and is not intended to represent the only forms in which the present disclosure may be constructed or utilized. The description sets forth the functions of the example and the sequence of steps for constructing and operating the example. However, the same or equivalent functions and sequences may be accomplished by different example embodiments.

Example embodiments relate to integrated circuits (ICs) and integrated circuit fabrication techniques applicable to, for example, In-Memory Computing (IMC), also sometimes referred to as Computing-in-Memory (CIM) or Processing-in-Memory (PIM). More specifically, the present disclosure describes techniques for implementing an apparatus that can be utilized in, for example, In-Memory Computing.

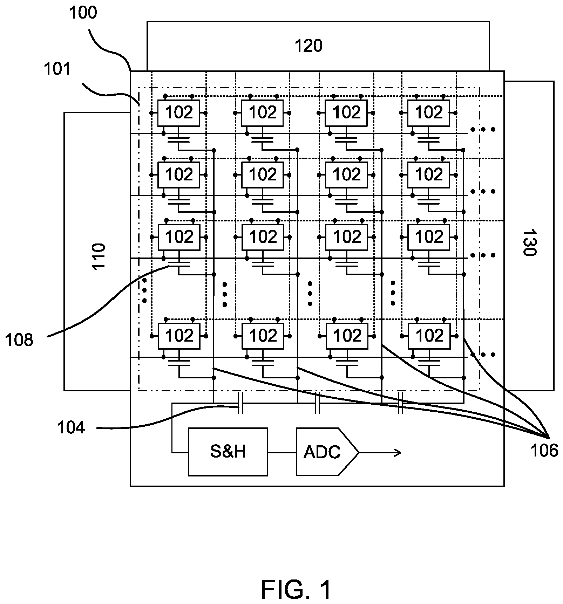

Fig. 1 illustrates a representation of an apparatus 100 according to an example embodiment. The apparatus 100 may be an IC configured to perform multiply-accumulate, MAC, operations. The apparatus 100 may be manufactured by, for example, integrated circuit manufacturing techniques, such as Complementary Metal-Oxide Semiconductor, CMOS, manufacturing techniques.

The multiply-accumulate (MAC) operation can function as a building block of a variety of computational processes used in, for example, digital signal processing and machine learning (ML) algorithms. For example, the convolution function, also sometimes referred to as cross-correlation or sliding dot product, can be produced by determining the integral of the product of the two functions for all possible values of shift. Convolution can be used in a variety of computational operations, including signal processing, image processing, neural networks, and others.

In computer systems, convolution may refer to a mathematical operation between two matrices often referred as an input window and a filter. For example, given a 10x10 matrix (the input window) and a 3x3 matrix (the filter), the process is to multiply the input window and the filter for each possible combination of positions as you superimpose the filter matrix over the input matrix. This can be accomplished by overlaying the filter at the first position, multiplying the overlapping values and adding them together to get the output, referred to herein as a dot product or partial sum. Next, the filter can be shifted one or more column/row over and the same calculations are repeated. Once at the end of the row/column, the filter can be shifted one or more row/column and the process repeated. This can continue until the end of the input matrix is reached.

The apparatus 100 may comprise a bitcell array 101 comprising a plurality of bitcells 102. Each bitcell 102 may be configured to store a bit (one or zero) and to multiply the stored bit with an input value.

The bitcell array 101 may be configured to, for example, represent a filter in a convolutional function, wherein an input value is multiplied with each bit stored in the bitcell 102. The stored bit in the bitcell 102 can represent a single bit of a full weight value of chosen bit depth. Example embodiments often relate to a weight value of 8 bits to maintain clarity, but it will be appreciated that a weight value may comprise any number of bits, such as 4 or 16 bits.

The apparatus 100 may further comprise an input buffer 110, configured to provide the input values to the bitcell array 101. Input values received from the input buffer 110 can have the same number of bits as the weights, but the input buffer 110 is to serially send input bits of a multibit input value to the bitcell array 101 one bit at a time starting with the least significant bit, LSB, and ending with the most significant bit, MSB, for a total of eight input cycles in the case of an 8-bit system. At each input cycle, the same input bit is fed into a full row of bitcells 102, but different rows can receive a different input bit depending on the input value received from the input window at that row position. The bitcells 102 can process the input bits in parallel.

Furthermore, the apparatus 100 may comprise an address decoder 130, configured to provide access individual bitcells in the bitcell array 101 by controlling switches in each bitcell 102.

As used herein, the term input value is used to refer to an entire N-bit input, whereas the term input bit is used to refer to a single bit of the N-bit input value. Furthermore, the term weight value is used to refer to an entire L-bit weight, and the term weight bit is used to refer to a single bit of the L-bit weight value. Embodiments of the bitcell array 101 are often represented as a row (vertical axis) - column (horizontal axis) matrix, however, it will be appreciated that the bitcell array 101 may be configured in any orientation deemed suitable by a person skilled in the art.

In charge domain CIM designs, multiple charged/depleted capacitors can be used to redistribute or couple stored charges to achieve an analog voltage that represents the MAC result.

Although only a specific number of bitcells 102 are shown in Fig. 1, it will be appreciated that the bitcell array 101 can comprise any suitable number of bitcells 102, for example, several hundred bitcells 102. The bitcell 102 states may be set or reset by a bit line Read/Write circuitry, BL-RW, circuitry 120.

The bitcell array 101 may be divided into regions, each of which can have a set of columns representing a different filter. The bitcell array 101 may be divided into several regions of, for example, the same size. The number of columns in each region can depend on the number of bits used to represent the filter weights.

Each filter weight may be represented by, for example, an 8-bit number occupying 8 columns of the bitcell array 101. Thus, each region may comprise eight columns of bitcells. However, the present techniques can be implemented for any suitable bit precision, including 4 bits and others. The weights in a particular region can represent a single filter which has been unrolled from the matrix form into one column. In some embodiments, the filter may be copied multiple times to the same column to account for multiple channels of an input. For example, in a system with a 4-by-4 filter matrix and four input channels, each column can comprise 64 bitcells (16 weights per filter times 4 channels). In the bitcell array, weight bit significance cam be represented by the position of the bit in the 8-bit region.

Input values received from, for example, input the buffer 110 can have the same number of bits as the weights. The input buffer 110 may serially send input bits of the multibit input to the bitcell array 101 one bit at a time starting with the least significant bit and ending with the most significant bit for a total of eight input cycles in the case of an 8-bit system. At each input cycle, the same input bit can be fed into a full row of bitcells, but different rows can receive a different input bit depending on the input value received from the input window at that row position. The bitcells can process the input bits in parallel.

At each input cycle, each bitcell can multiply the input bit with its own weight bit and output a zero charge if the result of the multiplication is zero or a non-zero charge if the result of the multiplication is one.

The apparatus 100 may comprise a capacitor mesh circuit 104. The capacitor mesh circuit 104 may comprise a plurality of signal lines 106. Wherein the output of each bitcell 102 is coupled to a signal line 106 in the capacitor mesh circuit 104 through at least one capacitor 108. Each signal line 106 is electrically coupled in the capacitor mesh circuit 104 such that the capacitor mesh circuit 104 forms a binary-weighted capacitive voltage divider between the signal lines 106 and a signal line 106 coupled to the outputs of bitcell array 101 column representing the most significant weight bit, MSWB, position of different weight values comprises the output of capacitor mesh circuit 104, the output comprising a partial MAC result.

The capacitor mesh circuit 104 may be integrated, at least partially, in between rows and/or columns of bitcell array 101 to maintain symmetry and therefore optimizing performance of apparatus 100.

The capacitor mesh circuit 104 may also be referred to as a capacitor mesh.

It is to be noted that a signal line 106 may be referred to as 'column' in the capacitor mesh circuit 104, as the illustrated arrangement in the examples are given so that columns represent a sum of the multiplications for a one weight bit of the weight values stored in the bitcell array 101.

Furthermore, embodiments of the capacitor mesh circuit 104 disclosed herein may comprise circuit arrangements that do not necessarily accumulate voltage for each column that is exactly the sum of the multiplications, but rather is used to represent the sum of the multiplications.

The partial MAC result may refer to a voltage or a charge value accumulated to the MSWB position in the bitcell array 101 each cycle of an input value, for example, N-bits. For example, the partial MAC result can comprise, for each cycle of an input value, the sum of the multiplications of the MSWB position and a binary-weighted sum of the multiplications of each non-MSWB position.

The term 'MSWB position' or 'non-MSWB' position may be expressed alternatively as 'MSWB column position' or 'non-MSWB column position'. In either case, a common signal line 106 of the same bit position of different weight values in a column of bitcell array 101 and/or capacitor mesh circuit 104 are referred to. In some cases, individual bits of a row of bitcell array 101 representing a weight value may be referred to as a row position. For example, the MSWB row position refers to the most significant bit, MSB, of a single weight value.

The term 'Non-MSWB row position' relates to each bit of a weight value other than the MSWB, for example, in the case of an 8-bit weight value, the last 7-bits including the least significant bit, LSB, of the weight value.

Furthermore, the apparatus 100 may comprise a sample and hold, S&H, -circuit to sample the voltage at the MSWB position each clock cycle of an input value to accumulate an analog MAC result. The apparatus 100 may further comprise an analog to digital converter, ADC, circuit to transform the analog MAC to a digital value, that may be stored in a memory, for example.

According to an example embodiment, an apparatus comprises a capacitor mesh circuit comprising a plurality of signal lines; and a bitcell array comprising a plurality of bitcells, wherein each bitcell of the bitcell array comprises a storage unit for storing a weight bit of a weight value and a multiplication unit configured to multiply the weight bit by an input bit of an input value and to provide a result of the multiplication to an output of the bitcell, and the output of each bitcell in a column of the bitcell array is coupled to corresponding signal line in the capacitor mesh circuit via at least one capacitor; wherein each signal line in the plurality of signal lines is electrically coupled such that the capacitor mesh circuit forms a binary-weighted capacitive voltage divider circuit between the plurality of signal lines; and a signal line coupled to the outputs of bitcells in a most significant weight bit, MSWB, column of the bitcell array comprises an output of the capacitor mesh circuit.

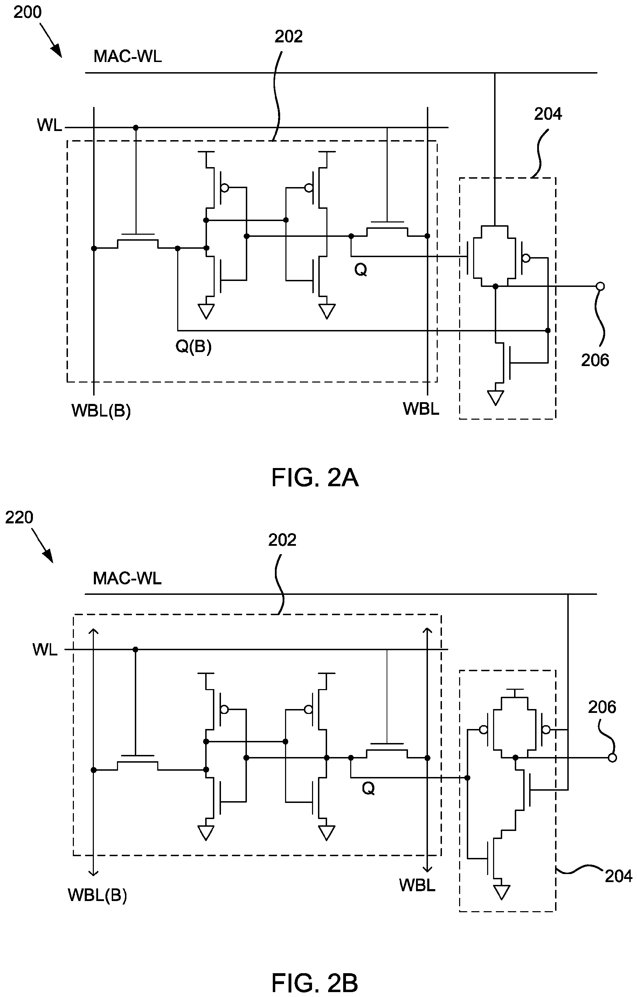

Fig. 2A illustrates a schematic representation of a bitcell 200 according to an example embodiment. The bitcell 200 illustrated in the example embodiment of Fig. 2A is an example of how at least some of the bitcells 102 of the apparatus 100 can be implemented.

In any embodiment, the bitcell 200 can comprise a storage unit 202 for storing the state of the bitcell 200 (1 or 0). The storage unit 202 can store, for example, a single bit of a multibit weight. The storage unit 202 may also be referred to as a bit storage unit, a bit storage, or similar. Each column of bitcell array 101 can represent the same bit position of different weights. Each row of bitcell array 101 can correspond to one weight and each bitcell 200 in a row can represent one bit of the weight. Write Bit Line, WBL, and Write Bit Line complement, WBL(B) are used to write a zero or one in storage unit 202, and access to storage unit 202 is determined by Write Line, WL through the two example NMOS transistors with their gates coupled to the WL. The stored bit of storage unit 202 is represented in Fig. 2A as 'Q' and it's complement as 'Q(B)'.

In the example embodiment of Fig. 2A, storage unit 202 comprises a six-transistor SRAM cell, however, it will be appreciated that other types of bit storage circuits may be used.

Furthermore, the example bitcell 200 may comprise a multiplication unit 204, to perform a bitwise multiplication with the stored bit Q, and an input bit may be provided through a MAC Write Line, MAC-WL. In the example of Fig. 2A, the multiplication unit 204 is a three transistor AND gate, wherein the output 206 of the bitcell 200 is the logical AND result of the multiplication unit 204. For example, if stored bit Q is 1, and the input bit through MAC-WL is 1, the result at output 206 is coupled to the MAC-WL, as the upper NMOS is open due to Q, the PMOS is open due to Q(B) and the lower NMOS is closed to due Q(B).

The multiplication unit 204 in the example embodiment of Fig. 2A is only one circuit that may perform the desired AND function, therefore it will be appreciated that other types AND gates may be used in the bitcell 200 however, the example multiplication unit 204 is disclosed as an example to minimize internal gate-switching for stationary weights.

The bitcell 200 may embody any bitcell 102 in bitcell array 101, however, example embodiments relate the example bitcell 200 to non-MSWB positions in the bitcell array 101, whereas an example of a NAND gate as multiplication unit 204 is presented for MSWB-positions, when calculating MAC using two's complement representation in the filter matrix (i.e., in bitcell array 101).

Fig. 2B illustrates a schematic representation of a bitcell 220 according to an example embodiment. The bitcell 220 can be used in the MSWB positions in the bitcell array 101. These may be referred to as MSB bitcells, or MSWB bitcells.

In the example embodiment of Fig. 2B, the bitcell 220 comprises a storage unit 202 and a bit-wise multiplication unit 204, similar to the bitcell 200, however the multiplication unit 204 of the bitcell 220 is a NAND gate. The NAND gate can be implemented as, for example, a four-transistor NAND gate. A NAND gate may used in the MSWB-position to perform a MSB inversion, which may be needed when calculating MAC in 2's complement. This solution may not require MSB inversion in the charge domain.

For example, if the weight values are represented in 2's complement form, the MSWB multiplication unit 204 can be a NAND gate and all other weight bits of lesser significance than the MSWB can be AND gates. Alternatively, if unsigned weight values are used, all the multiplication units may be, for example, a AND gate.

The bitcell 220 comprises an output 206, wherein the output 206 comprises a logical NAND value. For example, the output is zero only if both Q and MAC-WL are one.

Similarly to the bitcell 200 of Fig. 2A, the bitcell 220 of Fig. 2B comprises the same functionality with the MAC-WL, the WBL, the WBL(B) and the WL.

In the example embodiments of Fig. 2A and 2B, access (read and write) to the storage unit 202 can be enabled by the WL which can control the two access transistors. The access transistors can control whether the storage unit 202 should be coupled to the write bit lines WBL and WBL(B). The write bit lines WBL and WBL(B) can be bitwise complements that control the state of the storage unit 202, i.e., whether the storage unit stores a one or a zero.

The output of the storage unit 202 can be accessed at the outputs of the two cross-coupled inverters. The values on the two outputs can be bitwise complements that represent the value that was stored to the storage unit 202. For example, if the storage unit 202 stores a value of 1, then Q can be 1 and Q(B) can be 0. If the storage unit 202 stores a value of 0, then Q can be 0 and Q(B) can be 1.

In some embodiments, the multiplication unit 204 can comprise an AND gate for MSB bitcells and a NAND gate for non-MSB bitcells. In other embodiments, the multiplication unit may be implemented in other ways. The multiplication unit can perform a bitwise multiplication of a value stored in the storage unit 202 and a bit value provided via the MAC-WL. The multiplication unit can provide the result of the bitwise multiplication to the capacitor mesh circuit 104 presented in Fig. 1 by driving the at least one capacitor 108 in capacitor mesh circuit 104. The result may be represented by a charge, entering charge domain computation.

The bit value provided via the MAC-WL can represent the input bit received from input buffer 110.

The at least one capacitor 108 for each bitcell may be referred to as an output capacitor 108.

If the input bit and the weight bit are both 1, then output capacitor 108 will store a charge representing 1. Otherwise, if either the input bit or the weight bit equal 0, output capacitor 108 will be discharged.

According to an example embodiment, the multiplication unit of each bitcell in a column in the bitcell array representing a non-most significant bit, non-MSB, of a weight value is an AND gate; and the multiplication unit of each bitcell in a column in the bitcell array representing a most significant bit, MSB, of a weight value is a NAND gate.

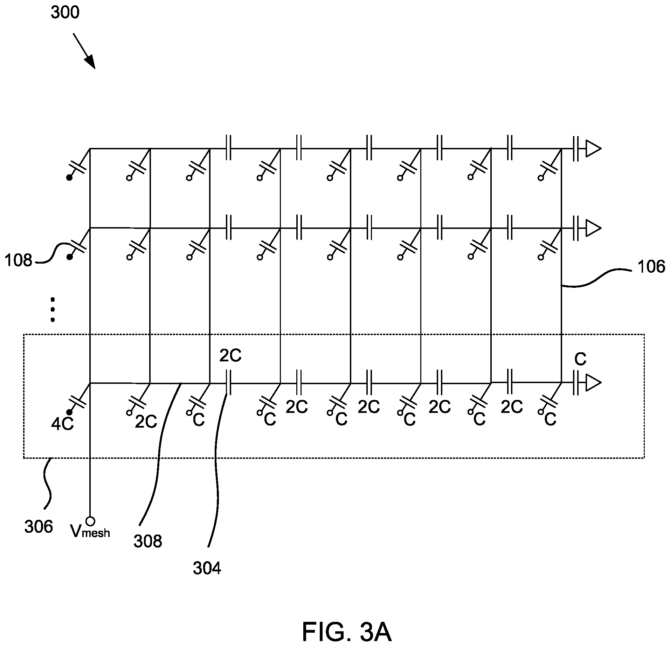

Fig. 3A illustrates a schematic representation of a capacitor mesh circuit 300 according to an example embodiment. The capacitor mesh circuit 300 may comprise the capacitor mesh circuit 104 presented in Fig. 1.

In Fig. 3A, each bitcell 102 may be electrically coupled to the capacitor mesh circuit 300 through at least one capacitor 108.

The at least one capacitor 108, which may be referred alternatively to as output capacitor 108, can store the multiplication result as a charge e.g., charge representing the multiplication result that accumulates to a driven plate connected to the output 206 of bitcells and a common plate which can be effectively shared between the output capacitors in the same column due to being coupled to one another via the signal line 106. The driven plate can be set to, for example, the supply voltage or ground depending on the multiplication result of the individual bitcell 200 or bitcell 220, while the common plate can be allowed to settle to an intermediate voltage representing the sum of the multiplication results for all of the bitcells 102 in a column.

The relationship between the voltage at the common plate and the ratio of high and low capacitors can be a linear function. Thus, the voltage at the common plate can indicate the ratio of high to low output capacitors and, by extension, the summation of the multiplication results. Accordingly, the binary digital multiplication result produced by the bitcells in a single column results is an analog voltage at signal line 106, that represents the sum of the multiplication results provided by the bitcells in the column. The capacitive voltage division arrangement of the capacitor mesh circuit 300 provides a detectable, binary-weighted charge at the MSWB signal line 106, which may be stored to a holding capacitor in a sample and hold, S&H, -circuit.

In the example capacitor mesh circuit 300, the capacitance of output capacitors 108 in each column are arranged such, that half of the charge accumulated to a signal line 106, is shared by a signal line 106 of one higher bit significance. This leads to a binary-weighted summation of each signal line 106 at the MSWB column in the capacitor mesh circuit 300. The MSWB column may then be sampled by a S&H circuit each clock cycle of an input value.

The capacitance of each capacitor in the capacitor mesh circuit 300 may be chosen to be an integer multiple of a reference capacitance value, such as 500 femtofarads, fF. The unit capacitance value may be chosen based on, for example, the clock speed or physical space between bitcells 102 in bitcell array 101.

In the example capacitor mesh circuit 300, the three most significant bits form a ratioed capacitive voltage divider, which may help reduce bottom plate parasitic capacitance that is formed in a classical C-2C voltage divider with bridge capacitors. The example capacitor mesh circuit 300 has a 4C-2C-C unit capacitance value for the first three MSBs, however, it is to be noted that other forms of unit capacitance values may be chosen, for example 8C-4C-2C-C for a four-bit ratioed capacitive voltage divider.

The 5 least significant bits in the example capacitor mesh circuit 300 are divided with a bridge capacitor 304 between column positions of a single row (i.e., one bridge capacitor 304 is assigned per one output capacitor 108).

The example capacitor mesh circuit 300 in Fig. 3A may comprise a plurality of rows, wherein a dotted line box 306 encloses one row to maintain clarity in the description. Each row may comprise a plurality of row positions 308, each row position 308 representing a sum of at least one bitwise multiplication result.

In the example capacitor mesh circuit 300, the five least significant bits are divided with the bridge capacitor 304 having a unit capacitance value of 2C, and one multiplication result of a bitcell 102 per row position 308.

In other embodiments, instead of 2C bridge capacitor 304 value - a 4C value for each bridge capacitor 304 could be used if, for example, two multiplication results per row position 308 is added to the same column. It is to be noted that other arrangements for a single row position 308 may be used, such as two or more output capacitor 108 per one row position 308. The bridge capacitor 304 value (and the grounding capacitor value) should then be chosen accordingly.

The structure illustrated in the example embodiment of Fig. 3A may be referred to as a hybrid ratioed-capacitor/C2C structure. The hybrid ratioed-capacitor/C2C structure can be implemented with the same number of capacitors as a full C2C structure. At least in some implementations, the hybrid ratioed capacitor/C2C structure can have a four times lower bottom plate parasitics induced nonlinear non-idealities by eliminating the first two stages of bridge capacitors 304.

The driven plate of each output capacitor 108 in the MSWB column position in Fig. 3A is illustrated with a black circle/dot, and the driven plate of each output capacitor 108 in non-MSWB column positions are illustrated with a white circle/dot.

The partial MAC result accumulates to the MSWB column position of the capacitor mesh circuit 300. The partial MAC result may be referred to as 'partial' because it represents the summation of the multiplication results for the bitcells in all the columns (i.e., single weight bit position) for a single input cycle (i.e., single input bit position). To obtain a full analog MAC result, at least N input cycles of an N-bit input value should be sampled to a holding-capacitor in a sample and hold circuit for N cycles.

The multiplication of the inputs and the weights can be conducted for each input bit individually. Accordingly, the partial MAC results are stored for each input cycle and added to the partial MAC results for each of the previous input cycles until the last bit of the input value has been processed.

Fig. 3A further illustrates an output node for capacitor mesh circuit 300, $V_{mesh}$, which may be coupled to a switch in a sample and hold circuit. It is to be noted, that the $V_{mesh}$ may refer to an output node in capacitor mesh circuit 300 or the voltage accumulated to that node.

The bit significance of the weights can be determined by the bit position. In the mesh, the leftmost column can represent the most significant bit and the rightmost column can represent the least significant bit. The arrangement of columns with the capacitors coupled between the columns creates a voltage divider circuit so that the effect of each successive column as measured at the output port, is reduced by half moving from the most significant bit to the least significant bit. In this way, the bit significance can be represented using the capacitors in the mesh, rather than capacitors that increase exponentially in size. This can enable bit-significance presentation at linear cost, with better matching characteristics and higher precision.

The example embodiment of Fig. 3A may be implemented in other ways, such as not using a ratioed capacitor configuration in the first three MSB's, and only coupling one weight value to one row in capacitor mesh circuit 104. One example may be constructed, by using an integer multiple of one for each at least one capacitor 108 and an integer multiple of 2C for each capacitor between signal lines 106.

According to an example embodiment, the output of the capacitor mesh circuit is configured to provide a partial multiply-accumulate, MAC, result and the partial MAC result comprises, for each cycle of an input value, a sum of multiplications of the MSWB column and a binary-weighted sum of the multiplications of each non-MSWB column.

According to an example embodiment, each capacitor in the at least one capacitor comprises a first capacitor, each first capacitor having a target capacitance of an integer multiple of a unit capacitance; each signal line comprises a plurality of row positions in the capacitor mesh circuit, wherein each row position is coupled to at least one first capacitor; row positions in each signal line are electrically coupled to each other; and the integer multipliers between the row positions form a capacitive voltage division of the binary-weighted capacitive voltage divider.

According to an example embodiment, the integer multiplier for each first capacitor of the MSWB signal line is four; the integer multiplier for each first capacitor of a second most significant weight bit signal line is two; the integer multiplier for each first capacitor of a third most significant weight bit signal line is one; wherein the MSWB signal line, the second most significant weight bit signal line and the third most significant weight bit signal line are coupled to each other with a short circuit and wherein: each signal line of lesser significance than the second most significant weight bit signal line is coupled to a signal line of one higher bit significance through at least one second capacitor, each second capacitor having a target capacitance of two times the unit capacitance; and each first capacitor of a signal line of lesser bit significance than the second most significant weight bit signal line has an integer multiplier of one; and a signal line of a least significant bit, LSB, is coupled to ground with at least one third capacitor, each third capacitor having a target capacitance equal to the unit capacitance.

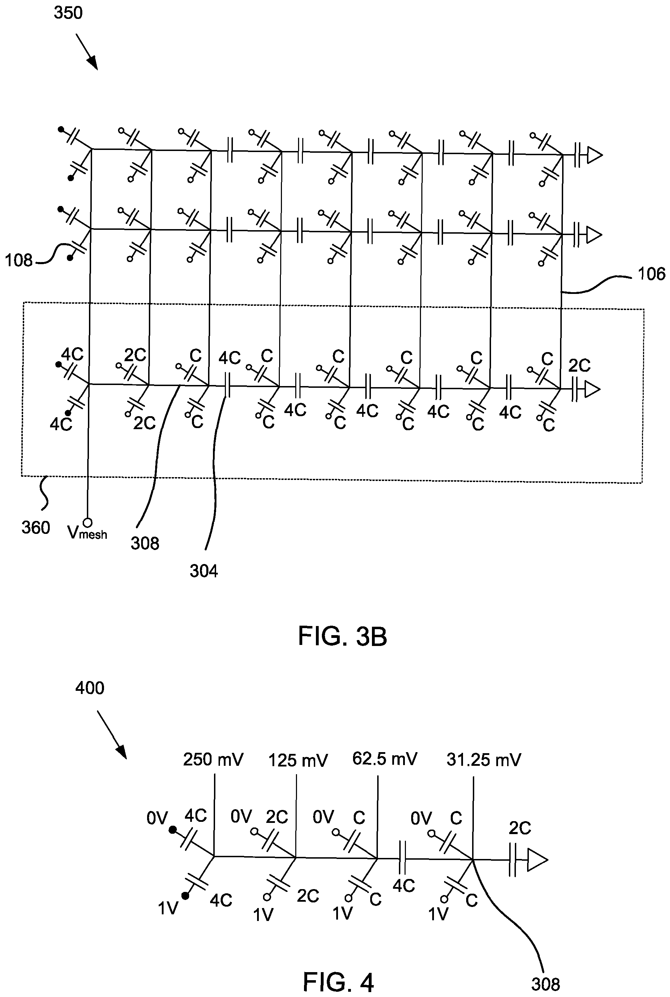

Fig. 3B illustrates a capacitor mesh circuit 350, wherein one row comprises a combination of two rows in the example capacitor mesh circuit 300 of Fig. 3A. Dotted line box 360 now encloses a 2x8 bit unit instance. The capacitor mesh circuit 300 of Fig. 3A can be electrically equivalent to the capacitor mesh circuit 350 of Fig. 3B and is used to demonstrate the behavior of capacitor mesh circuit 300 and the capacitor mesh circuit 350, for example, whether one bridge capacitor 304 is implemented for one row of bitcells in bitcell array 101 or whether one bridge capacitor 304 is used for two rows of bitcells. Individual rows of bitcells may therefore be unused in bitcell array 101, and the functionality of the capacitor mesh circuit 300 (and the capacitor mesh circuit 350) stay the same as technically each addition of bridge capacitor 304 in a column adds the capacitance value of bridge capacitor 304 to the total effective capacitance between adjacent columns.

Fig. 4 illustrates a 4-bit weight value capacitor mesh circuit 400 comprising a single 2x4 bit unit instance, where two weight values are summing to each row position 308, to clarify the effect of the capacitor mesh circuit 300 and the capacitor mesh circuit 350 disclosed in Fig. 3A and Fig. 3B. The first weight value is 0000 and the second weight value is 1111, and no bit-inversion is performed for the MSWB (the multiplication unit is not a NAND-gate in this example) as both weight values are unsigned. An input bit of 1 is fed to MAC-WL of both weight values, therefore the upper weight value (0000) does not increase the total charge accumulated to each row position.

The values of 250 mV, 125 mV, 62.5 mV and 31.25 mV are illustrated as the contribution of each weight bit of the lower weight value to the MSWB position, when each output capacitor is driven by a 1V signal (e.g., the supply voltage). It is to be noted that the voltage values illustrated in Fig. 4 may not necessarily be the voltages at the nodes, but the contribution of each weight bit (of the lower weight value) to the MSWB row position.

The effect of a single bit is halved twice, since one row position is driven by two weight bits (i.e., two rows are presented as one unit instance, similar to Fig. 3B), halving the total effect once, and the capacitive voltage division of each row position then halves the voltage second time. The effect at the MSWB position by a single weight value for a single input bit activation at the MAC-WL could be expressed as given by equation 1:

$$\frac{1V}{2*2*2^0} + \frac{1V}{2*2*2^1} + \frac{1V}{2*2*2^2} + \frac{1V}{2*2*2^3} = 468.75\,mV \quad (1),$$

therefore, for each weight value contribution (for each corresponding input bit), the total contribution of a single weight value in bitcell array 101 during a single input bit activation may be expressed as in equation 2:

$$\frac{1}{2*M}\sum_{i=0}^{L} input\,bit * \frac{weight\,bit_i}{2^i} \quad (2),$$

where M is the number of weight values in bitcell array 101 and L is the bit depth of each weight value and index i runs over each bit value of the weight.

During vector matrix multiplication (VMM) computation, M input activations can be simultaneously applied onto each MAC-WL (see Fig. 2A and 2B) in bitcell array 101 in little endian bit-serial fashion. Accumulation of charges across clock cycles can be detected using a sample hand hold (S&H) circuit.

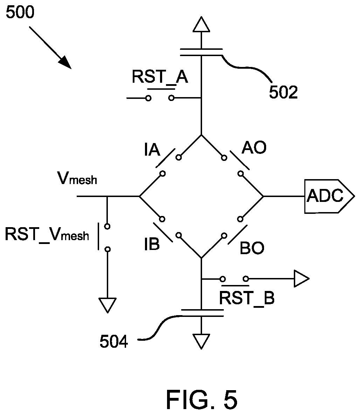

Fig. 5 illustrates a schematic representation of a sample and hold, S&H, -circuit 500 according to an example embodiment.

S&H circuit 500 illustrated in the example embodiment of Fig. 5 can be utilized as a so-called ping-pong buffer, wherein an analog MAC result accumulated to a first holding capacitor 502 over whole N cycles of an input value is sampled by an ADC circuit while a second holding capacitor 504 accumulates the next input cycle. However, a single holding capacitor S&H circuit may be used. S&H circuit 500 may comprise control switches and two holding capacitors. The two holding capacitors can have the same capacitance. The S&H circuit can be electrically coupled to an analog to digital converter (ADC) via switches.

Herein, resetting a capacitor or a plurality of capacitors, such as capacitor mesh circuit 300, may refer to electrically coupling the capacitor or the plurality of capacitors to ground in order to discharge the capacitor or the plurality of capacitors (i.e., to 0V or negative supply voltage).

Capacitor mesh circuit 300 can be reset using the RST_V$_{mesh}$ switch. The first holding capacitor 502 can be reset using the RST_A switch. The second holding capacitor 504 can be reset using the RST_B switch. The first holding capacitor 502 can be coupled to the capacitor mesh circuit 300 using the IA switch. The second holding capacitor 504 can be coupled to the capacitor mesh circuit 300 using the IB switch. The first holding capacitor 502 can be coupled to the ADC using the AO switch. The second holding capacitor 504 can be coupled to the ADC using the BO switch.

According to an example embodiment, the apparatus may further comprise a sample-and-hold circuit comprising at least one holding capacitor, the at least one holding capacitor electrically couplable to sample a voltage at the output of the capacitor mesh circuit.

According to an example embodiment, the sample-and-hold circuit may comprise a first holding capacitor and a second holding capacitor, the first holding capacitor and the second holding capacitor being electrically couplable to the output of the capacitor mesh circuit to sample the voltage at the output of the capacitor mesh circuit for each cycle of an input value of size N to obtain an analog MAC result.

According to an example embodiment, the sample-and-hold circuit may further comprise: a first coupling switch electrically coupled between the first holding capacitor and the output of the capacitor mesh circuit; a second coupling switch electrically coupled between the second holding capacitor and the output of the capacitor mesh circuit; a first reset switch electrically coupled between the first holding capacitor and ground; a second reset switch electrically coupled between the second holding capacitor and ground; and a mesh reset switch electrically coupled between the output of the capacitor mesh circuit and ground; wherein the apparatus further comprises a sample and-hold control, SHCTRL, circuit configured to control the first coupling switch, the second coupling switch, the first reset switch, the second reset switch, and the mesh reset switch to obtain the analog MAC result.

According to an example embodiment, the apparatus may further comprise an analog-to-digital converter, ADC, circuit, wherein the ADC circuit is configured to convert the analog MAC result to a digital MAC result, and the sample-and-hold circuit may further comprise: a first output switch electrically coupled between the first holding capacitor and the ADC circuit; and a second output switch electrically coupled between the second holding capacitor and the ADC circuit; wherein the SHCTRL circuit is further configured to control the first output switch and the second output switch to connect the first holding capacitor and the second holding capacitor the ADC circuit in an alternating fashion.

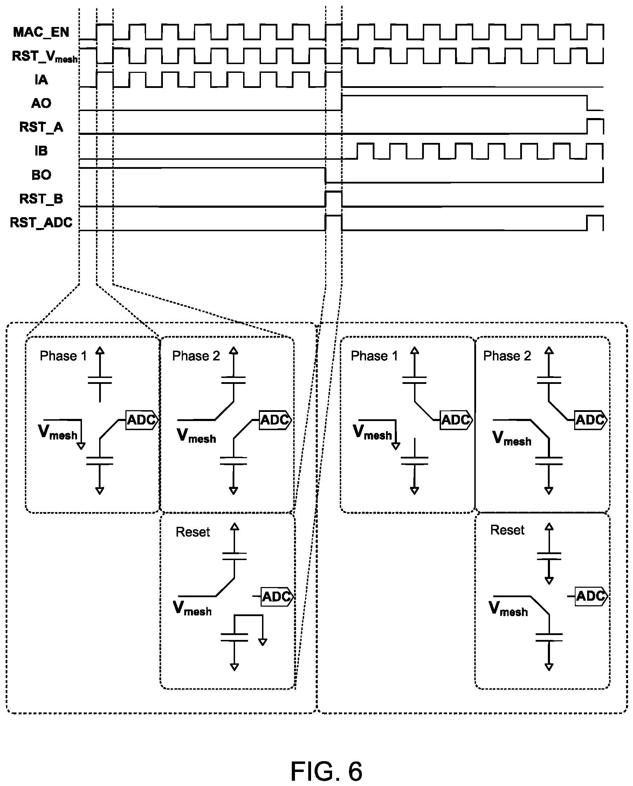

Herein, "ping-pong" can refer to functionality in which the S&H circuit 500 alternates which of the two holding capacitors is accumulating charge from the capacitor mesh circuit and which is coupled to the ADC. The S&H circuit 500 can ping-pong every N cycles to allow pipelining between the accumulation of charges and the ADC operation. For more detailed operation, refer to Fig. 6. While the first holding capacitor 502 is accumulating charge(s) from the capacitor mesh circuit 300 during the N cycles of bit-serial multiply-and-accumulate (MAC) computation, ADC operation is performed on the charge(s) previously accumulated on the second holding capacitor 504. The role of the first holding capacitor 502 and the second holding capacitor 504 can reverse every N cycles.

In any embodiment, the ADC can comprise, for example, a successive approximation register (SAR) ADC or any other type of ADC suited to convert the analog MAC result to a digital format.

Fig. 6 illustrates nine timing diagrams (MAC_EN, RST_$V_{mesh}$, IA, AO, RST_A, IB, BO, RST_B, RST_ADC) of separate clock/control signals required to control the S&H circuit 500, for example. Fig. 6 further illustrates switch positions of the S&H circuit 500 during a single cycle (e.g., as Phase 1, Phase 2, Reset).

The Bitcell array 101 can be fed bit-serial input in an N cycle period. Each input value can be multiplied by the weights in bitcell array 101 one input bit at a time. The processing of one input bit can take place during one input cycle. Thus, for an 8-bit system, for example, the full input value can be processed in eight input cycles.

The 9 illustrated clock/control signals may be controlled and/or generated by, for example, a sample and hold control circuit, SHCTRL. The SHCTRL circuit may be integrated in, for example, the input buffer 110 presented in Fig. 1.

Referring to Fig. 6, MAC_EN enables a single cycle partial MAC result calculation to the output of the capacitor mesh circuit 300 ($V_{mesh}$). The MAC_EN signal may be, for example, a signal that is generated by the SHCTRL circuit or the input buffer 110.

The IA switches for 8 cycles of MAC_EN, during which, for example, the first holding capacitor 502 samples each partial mac result at $V_{mesh}$, therefore halving the charge each cycle of the IA. This creates the input bit significance, as after 8 cycles the first accumulated charge at the first holding capacitor 502 have been halved 8 times.

During the eight MAC_EN cycle rising edge, the ADC is reset with RST_ADC, and the ADC is then connected to the first holding capacitor 502 during/after the falling edge of the eight MAC_en cycle with AO switch.

The second holding capacitor 504 is disconnected from the ADC by switching BO state during the eight MAC_EN cycle rising edge, and RST_B is then enabled simultaneously.

The second holding capacitor 504 may then proceed to sample the next input value cycle by switching IB to $V_{mesh}$. The ping-pong design of the example S&H circuit 500 can provide a fast way to perform analog to digital conversion with two holding capacitors for each S&H circuit in the apparatus 100 and giving the ADC sufficient time to perform the conversion.

The first holding capacitor 502 may be reset by RST_A after the ADC has converted successfully converted the value stored in the first holding capacitor 502. The timing diagram illustrated in Fig. 6 may then, after two 8-bit sampling cycles, start again from the start.

The ADC implemented should take less or equal to (N-0.5) cycles to perform the analog-to-digital conversion. Therefore, the ADC may be reset every last cycle of a partial MAC calculation.

The S&H circuit 500 can use a two-phase clock. During a first phase, a holding capacitor can be disconnected from capacitor mesh circuit 300. If the capacitance of the capacitive mesh $C_{mesh}$ is substantially equal to the capacitance of the holding capacitor $C_{hold}$, the total charge is split substantially equally between the capacitor mesh circuit 300 output and the holding capacitor. The charge can correspond to previous phase on the holding capacitor. After the disconnecting the capacitor mesh can be reset in preparation of the next set of input/activations.

During a second phase, the holding capacitor can be connected to capacitor mesh circuit 300 while the input activation is asserted.

As the first phase and the second phase are repeated, the charge of the holding capacitor halves each cycle while accumulating with the current charge from the capacitor mesh. Thus, the charge $Q_h$ in the holding capacitor during a cycle $t$ + 1 is

$$Q_h(t + 1) = \frac{1}{2}\left(Q_{mesh}(t + 1) + \frac{1}{2}Q_h(t)\right)$$

, where $Q_{mesh}$ is the charge in the capacitive mesh. This represents the bit-significance in little endian order.

The first and second phase disclosed above can be repeated for N-1 cycles for one of the holding capacitors.

During this procedure, the other holding capacitor can be electrically coupled to the ADC and the ADC can perform an analog-to-digital conversion on the voltage of the other holding capacitor. Then, the other holding capacitor can be reset. This may take, for example, 0.5 cycles. After this, the holding capacitor that accumulated charge from the capacitor circuit for N-1 cycles can be electrically coupled to the ADC and the holding capacitor that was previously coupled to the ADC can accumulate charge from the capacitor mesh for N-1 cycles using the two phases disclosed above. This procedure can be repeated in a ping-pong fashion any number of times.

Though one specific example of controlling a S&H circuit to perform the analog MAC calculation, other S&H architectures may be used, such as controlling three holding capacitors for example.

At least some embodiments disclosed herein can be utilized in a MAC accelerator apparatus with charge domain CIM modules. Each CIM module can comprise the apparatus 100.

A top-level accelerator can manage the data organization and mapping of various forms of machine learning layers to the CIM macros in order to perform MAC operations with multibit inputs, multibit weights, and multibit output precisions. The CIM modules can compute in the charge domain, where the inputs are applied to the macro bit-serially whereas the weight bits are distributed across multiple columns of memory bitcells.

The bitcells can perform a binary multiplication in the digital domain, and the result determines the state of an output of the bitcell. The outputs of a column of bitcells can be coupled to the capacitor mesh in a manner disclosed herein.

The capacitor mesh circuit can form a hybrid ratioed-capacitor/C2C structure that can accumulate charges over the columns. The sample-and-hold (S&H) circuit coupled to the capacitor mesh can accumulate charge over multiple input cycles, representing the sum of each MAC result, accounting for the input bit significance. The charge from the S&H circuit can be pipelined to the ADC in a ping-pong fashion.

According to an example embodiment, the SHCTRL circuit is further configured to, by controlling the first coupling switch, the second coupling switch, the first reset switch, the second reset switch, the mesh reset switch, the first output switch, and the second output switch, to: accumulate partial MAC results over a first plurality of input cycles to the first holding capacitor as a first analog MAC result; accumulate partial MAC results over a second plurality of input cycles to the second holding capacitor as a second analog MAC result; and during the second plurality of input cycles, provide the first MAC result to the ADC circuit.

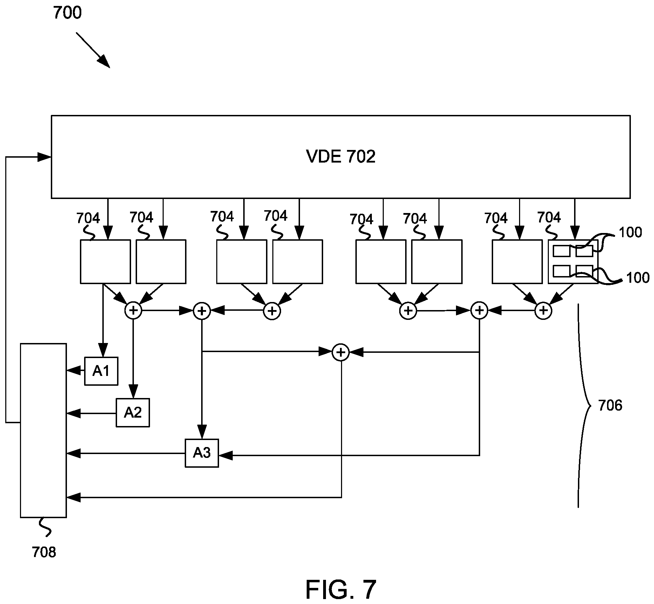

Fig. 7 is a block diagram of a compute-in-memory (CIM) device 700 with multiple CIM modules in accordance with example embodiments. Each CIM module may comprise the apparatus 100. Further, each CIM module can comprise other components, such as a S&H circuit and an ADC. The CIM device 700 shown in FIG. 7 demonstrates the ability to combine multiple CIM modules to handle a wide variety of system configurations. The CIM device 700 of FIG. 7 may be configured to process an input window measuring 512 input values across, and each CIM module is configured to handle 64 input values. Therefore, 8 CIM modules are used to cover the entire 512-bit input window. Input is received from a vector data editor, VDE, 702 which handles data arbitration to and from the CIM macros.

Additionally, the CIM device 700 may also be configured to process the input using a total of 64 filters, while each CIM module in this example can only hold a total of 16 filters. To extend the capability of the system from 16 filters to 64 filters, the CIM modules are grouped in modules sets 704, each of which includes 4 separate CIM modules that share the 64 bits of input from VDE 702.

The MAC results from each set of CIM modules may be added together using an arithmetic unit array (AUA) 706. Arithmetic unit array 706 is an adder tree that can be controlled to sum the MAC results in a variety of ways, depending on the system design and the desired results. In some configurations, the MAC results from each CIM module set 704 is received individually through an A1 multiplexer. For the sake of clarity, only one signal line to the A1 multiplexer is shown. However, it will be appreciated that additional signal lines will connect each of the CIM module sets 704 to the A1 multiplexer. The A1 multiplexer can report the results from each CIM module set 704 to VDE 702 individually in serial fashion.

In some configurations, the MAC results from pairs of CIM module sets 704 can be added together at a summing node before being reported to the VDE 702 through an A2 multiplexer. Again, although one signal line is shown to the A2 multiplexer, there will be a signal line from each summing node corresponding with the pairs of CIM module sets. The A2 multiplexer can report the summed results from each pair of CIM module sets 804 to the VDE serially in 4 steps.

In similar fashion, an A3 multiplexer can be selected to report the summed results from half of the CIM module sets 704 to the VDE 702 in two steps. Additionally, all of the CIM module sets 704 may be added together and reported to the VDE 702 in one step. A master multiplexer 708 can be used to determine which reporting configuration will be applied.

It will be appreciated that the specific details described in Fig. 7 are only example implementation details and that a wide variety of alternative configurations can be implemented. For example, various changes may be made to the number of CIM module sets 704, the number of CIM modules per CIM module set 704, the number of inputs per CIM module, and others without departing from the scope as defined by the appended claims.

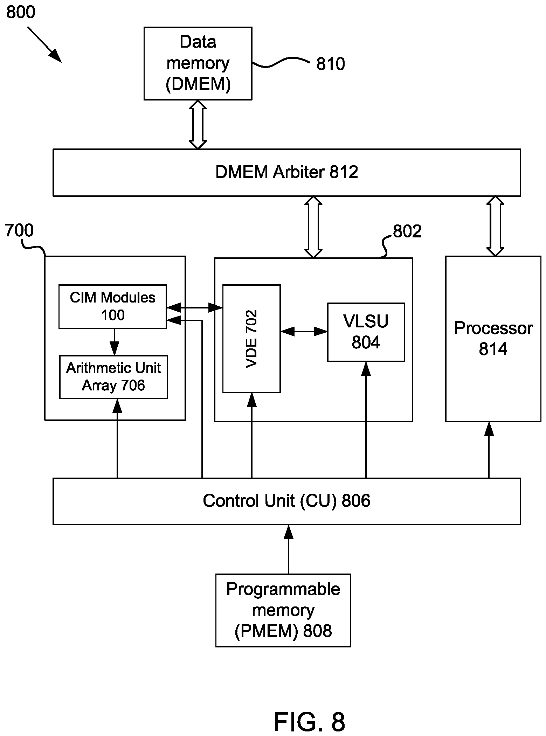

Fig. 8 is a block diagram of an example CIM system 800 in accordance with example embodiments. The CIM system 800 includes the CIM device 700 presented in FIG. 7, which includes the CIM modules 100 and the arithmetic unit array 706. The CIM device 700 receives input data from a vector data unit (VDU), VDE, 802, which includes the vector data editor 702 shown in Fig. 7. The Vector data unit 802 also includes a programmable vector load/store unit (VLSU) 804 coupled to the VDE 702. The VLSU 804 controls read and write operations and buffer the inputs or results.

The CIM system 800 may also include a control unit (CU) 806 that controls the operation of the CIM device 700 in accordance with program instructions stored to a program memory (PMEM) 808. For example, the control unit 806 can generate control signals that configure the CIM modules 100 by setting the weight values of bitcells included in bitcell array(s). The control unit 806 can also generate signals for configuring the arithmetic unit array 706 to determine how the MAC results are summed and reported. The control unit 806 may be any suitable type of logic unit, such as a microcontroller, an Application Specific Integrated Circuit (ASIC), a Field Programmable Gate Array (FPGA), or an arrangement of logic gates implemented in one or more integrated circuits, for example.

Input data and filter weight data may be stored to a data memory (DMEM) 810 and communicated to the CIM device 700 through the vector data editor 702. The data memory 810 may be any volatile or non-volatile data storage device, such as a hard drive, solid state drive, and others. Memory access to data memory 810 may be controlled by a data bus or arbiter 812.

The CIM system 800 can also include a general-purpose processor 814, which may be any suitable type of central processing unit (CPU) or reduced instruction set computer (RISC). The processor 814 can be used to provide communication between the CIM system 800 and other computing units or peripheral devices. For example, the processor 814 may be coupled to a network that allows the CIM system 800 to communicate with additional remote computing systems and devices. The processor 814 may also be used to specify the parameters of the CIM operations, such as providing the input data and filter weight data to be processed. Processor 814 can also be used to initiate mathematical operations on the data and receive results.

The block diagram of FIG. 8 is not intended to indicate that the CIM system 800 is to include all of the components shown in FIG. 8. Further, the CIM system 800 may include any number of additional components not shown in FIG. 8, depending on the details of a specific implementation.

Furthermore, processor 814 may be capable of executing the stored instructions. In an example embodiment, the processor 814 may be embodied as a multi-core processor, a single core processor, or a combination of one or more multi-core processors and one or more single core processors. For example, the processor 814 may be embodied as one or more of various processing devices, such as a coprocessor, a microprocessor, a controller, a digital signal processor (DSP), a processing circuitry with or without an accompanying DSP, or various other processing devices including integrated circuits such as, for example, an application specific integrated circuit (ASIC), a field programmable gate array (FPGA), a microcontroller unit (MCU), a hardware accelerator, a special-purpose computer chip, or the like. In an example embodiment, processor 814 may be configured to execute hard-coded functionality. In an example embodiment, processor 814 is embodied as an executor of software instructions, wherein the instructions may specifically configure processor 814 to perform the algorithms and/or operations described herein when the instructions are executed.

The Data memory 810 and/or programmable memory 808 may be embodied as one or more volatile memory devices, one or more non-volatile memory devices, and/or a combination of one or more volatile memory devices and non-volatile memory devices. For example, data memory 810 may be embodied as semiconductor memories (such as mask ROM, PROM (programmable ROM), EPROM (erasable PROM), flash ROM, RAM (random access memory), etc.).

When the CIM system 800 is configured to implement some functionality, some component and/or components of the CIM system 800, such as the processor 814 and/or the data memory 810, may be configured to implement this functionality. Furthermore, when the processor 814 is configured to implement some functionality, this functionality may be implemented using program code comprised, for example, in programmable memory 808. For example, if the CIM system 800 is configured to perform an operation, the programmable memory 808 and the computer program code can be configured to, with the processor 814, cause the CIM system 800 to perform that operation.

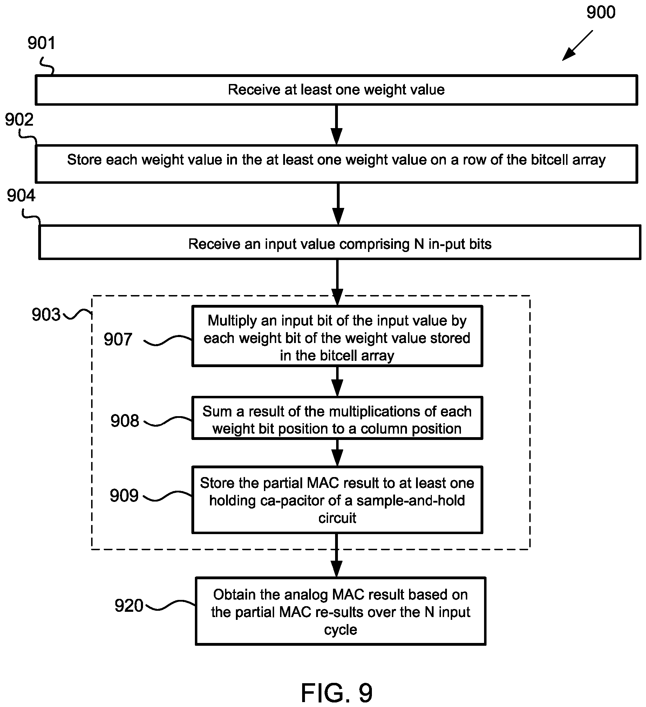

Fig. 9 illustrates a method 900 according to an example embodiment, which may be performed by, for example, CIM system 800 comprising apparatus 100.

According to an embodiment, a method 900 comprises receiving 901 at least one weight value comprising M weight bits.

The method 900 may further comprise storing 902 each weight value in the at least one weight value on a row of the bitcell array, wherein the weight value is distributed across M adjacent columns of bitcells as weight bits.

The method 900 may further comprise receiving 904 an input value comprising N input bits.

The method 900 may further comprise computing 903 an analog multiply-accumulate, MAC, result representing summed products of the input value and the at least one weight value, wherein the computing the analog MAC result comprises, for each of N input cycles: multiplying 907 an input bit of the input value by each weight bit of the weight value stored in the bitcell array, summing 908 a result of the multiplications of each weight bit position to a column position in a binary-weighted capacitive voltage divider circuit thus obtaining a partial MAC result at a most significant weight bit, MSWB, column position of the binary-weighted capacitive voltage divider circuit, wherein the partial MAC result comprises a sum of result of the multiplications of the MSWB column position and a binary-weighted sum of result of the multiplications of each non-MSWB column position, and storing 909 the partial MAC result to at least one holding capacitor of a sample-and-hold circuit.

The method 900 may further comprise obtaining 920 the analog MAC result based on the partial MAC results over the N input cycle.

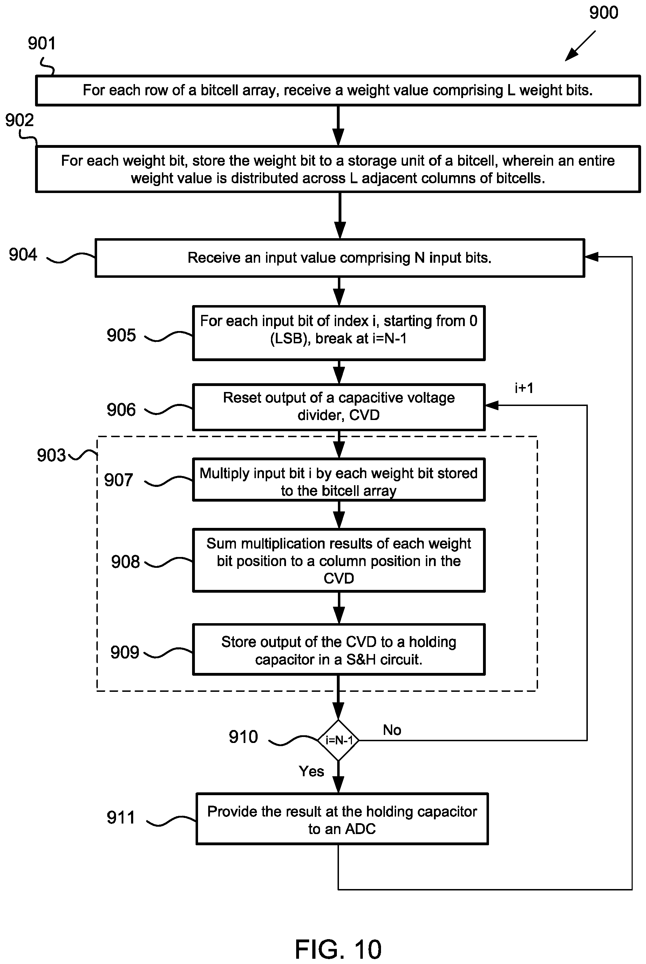

Fig. 10 illustrates a method 900 according to an example embodiment, which may be performed by, for example, CIM system 800 comprising apparatus 100.

At operation 901, the method 900 may comprise: for each row of a bitcell array, receiving a weight value comprising L weight bits. The bitcell array may comprise, for example, bitcell array 101 presented in Fig. 1.

At operation 902, the method 900 may comprise: for each weight bit, storing the weight bit to a storage unit of a bitcell, wherein an entire weight value is distributed across L adjacent columns of bitcells. Each bitcell may comprise, for example, the bitcell 200 and/or the bitcell 220 and the storage unit may comprise the storage unit 202 illustrated in Figs. 2A and 2B.

At operation 904, the method 900 may comprise: receiving an input value comprising N input bits. The input value may be provided by, for example input buffer 110 or vector data editor 702.

The method 900 then may comprise, at operation 905, a loop calculating over N input bits of the received input value. In method 900, the loop is being illustrated as having an index i starting from bit 0 (LSB) and looping to N-1.

At operation 906, the method 900 may comprise: Reset output of a capacitive voltage divider circuit, for example capacitor mesh circuit 300.

At operation 903, the method 900 may comprise: computing an analog MAC result representing summed products of the input values and the weight values for each row of the bitcell array. The operation 903 may comprise, for example, performing operations 907 - 909.

At operation 907, the method 900 may comprise: multiplying input bit of index i by each weight bit stored to the bitcell array. The multiplication may be performed by, for example, multiplication unit 204 presented in Fig. 2A (e.g., an AND-gate).

At operation 908, the method 900 may comprise: summing multiplication results of each weight bit position to a column position in the capacitive voltage divider circuit. A column position in the capacitive voltage divider circuit may comprise, for example, signal line 106.

At operation 909, the method 900 may comprise: storing output of the capacitive voltage divider to a holding capacitor in a sample and hold circuit. The sample and hold circuit may comprise, for example, the S&H circuit 500 presented in Fig. 5. The output of the capacitive voltage divider may comprise, for example, the most significant weight bit position in the bitcell array.

At operation 910, the method 900 may comprise a Boolean check to verify if index i has executed over each input bit. If not, then method 900 may comprise performing the loop again at operation 906. If no, then method 900 may proceed to next operation.

At operation 911, the method 900 may comprise: providing the result at the holding capacitor to an analog to digital converter, ADC. E.g., when calculations over N input values have been performed, the result at the holding capacitor may comprise the "analog MAC result" presented at operation 903. The ADC may comprise, for example, a SAR-ADC. However, it will be appreciated that other types of ADC's may be used to perform method 900.

Furthermore, Fig. 6 may be consulted for more details on how to perform method 900. E.g., how the sample and hold circuit should be controlled.

According to an example embodiment, the apparatus may further comprise a MAC Write Line, MACWL, decoder circuit, wherein the MACWL decoder circuit is configured to serially send input bits of the input value to the bitcell array to be multiplied by the weight value.

According to an example embodiment, the apparatus may further comprise: an address decoder circuit configured obtain and address and to set a bitcell corresponding to the address to a Read and Write state; and a Read and Write, R/W, -circuit, configured to set or reset storage units of the bitcell corresponding to the address.

According to an example embodiment, a method comprises: receiving at least one weight value comprising M weight bits; storing each weight value in the at least one weight value on a row of the bitcell array, wherein the weight value is distributed across M adjacent columns of bitcells as weight bits; receiving an input value comprising N input bits; computing an analog multiply-accumulate, MAC, result representing summed products of the input value and the at least one weight value, wherein the computing the analog MAC result comprises: for each of N input cycles: multiplying an input bit of the input value by each weight bit of the weight value stored in the bitcell array; summing a result of the multiplications of each weight bit position to a column position in a binary-weighted capacitive voltage divider circuit thus obtaining a partial MAC result at a most significant weight bit, MSWB, column position of the binary-weighted capacitive voltage divider circuit, wherein the partial MAC result comprises a sum of result of the multiplications of the MSWB column position and a binary-weighted sum of result of the multiplications of each non-MSWB column position; and storing the partial MAC result to at least one holding capacitor of a sample-and-hold circuit; and obtaining the analog MAC result based on the partial MAC results over the N input cycle.

According to an example embodiment, the computing the analog MAC result may further comprise: accumulating the partial MAC results over a first plurality of N input cycles to a first holding capacitor as a first analog MAC result; and accumulating the partial MAC results over a second plurality of N input cycles to a second holding capacitor as a second analog MAC result and, during the second plurality of N input cycles, providing the first MAC result to an ADC.

According to an example embodiment, a compute in memory, CIM, device comprises at least one CIM module, wherein each CIM module in the at least one CIM module may comprise embodiments of the apparatus, and the CIM device may further comprise a controller configured to perform the method.

An apparatus may comprise means for performing any aspect of the method(s) described herein. According to an example embodiment, the means comprise at least one processor, and memory comprising program code, the at least one processor, and program code configured to, when executed by the at least one processor, cause performance of any aspect of the method.

The functionality described herein can be performed, at least in part, by one or more computer program product components such as software components. Alternatively, or in addition, the functionality described herein can be performed, at least in part, by one or more hardware logic components. For example, and without limitation, illustrative types of hardware logic components that can be used include Field-programmable Gate Arrays (FPGAs), Application-specific Integrated Circuits (ASICs), Application-specific Standard Products (ASSPs), System-on-a-chip systems (SOCs), Complex Programmable Logic Devices (CPLDs), and Graphics Processing Units (GPUs).

Any range or device value given herein may be extended or altered without losing the effect sought. Also any example embodiment may be combined with another example embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts are intended to be within the scope of the claims.

It will be understood that the benefits and advantages described above may relate to one example embodiment or may relate to several example embodiments. The example embodiments are not limited to those that solve any or all of the stated problems or those that have any or all of the stated benefits and advantages. It will further be understood that reference to 'an' item may refer to one or more of those items.

The steps of the methods described herein may be carried out in any suitable order, or simultaneously where appropriate. Additionally, individual blocks may be deleted from any of the methods without departing from the spirit and scope of the subject matter described herein. Aspects of any of the example embodiments described above may be combined with aspects of any of the other example embodiments described to form further example embodiments without losing the effect sought.

The term 'comprising' is used herein to mean including the method, blocks or elements identified, but that such blocks or elements do not comprise an exclusive list and a method or apparatus may contain additional blocks or elements.

It will be understood that the above description is given by way of example only and that various modifications may be made by those skilled in the art. The above specification, examples and data provide a complete description of the structure and use of exemplary embodiments. Although various example embodiments have been described above with a certain degree of particularity, or with reference to one or more individual example embodiments, those skilled in the art could make numerous alterations to the disclosed example embodiments without departing from the spirit or scope of this specification.

**Claims**

1. An apparatus (100) comprising:

a capacitor mesh circuit (104, 300, 350) comprising a plurality of signal lines (106); and
a bitcell array (101) comprising a plurality of bitcells (102, 200, 220), wherein each bitcell (102, 200, 220) of the bitcell array (101) comprises a storage unit (202) for storing a weight bit of a weight value and a multiplication unit (204) configured to multiply the weight bit by an input bit of an input value and to provide a result of the multiplication to an output (206) of the bitcell (102, 200, 220), and the output of each bitcell in a column of the bitcell array (101) is coupled to corresponding signal line in the capacitor mesh circuit (104, 300, 350) via at least one capacitor (108);
wherein each signal line in the plurality of signal lines (106) is electrically coupled such that the capacitor mesh circuit (104, 300, 350) forms a binary-weighted capacitive voltage divider circuit between the plurality of signal lines (106); and
a signal line coupled to the outputs of bitcells in a most significant weight bit, MSWB, column of the bitcell array (101) comprises an output of the capacitor mesh circuit (104, 300, 350).

2. The apparatus (100) of claim 1, wherein the output of the capacitor mesh circuit (104, 300, 350) is configured to provide a partial multiply-accumulate, MAC, result and the partial MAC result comprises, for each cycle of an input value, a sum of multiplications of the MSWB column and a binary-weighted sum of the multiplications of each non-MSWB column.

3. The apparatus (100) of claim 2, wherein:

   each capacitor in the at least one capacitor (108) comprises a first capacitor, each first capacitor having a target capacitance of an integer multiple of a unit capacitance;
   each signal line comprises a plurality of row positions (308) in the capacitor mesh circuit (104, 300, 350), wherein each row position is coupled to at least one first capacitor;
   row positions in each signal line are electrically coupled to each other; and
   the integer multipliers between the row positions form a capacitive voltage division of the binary-weighted capacitive voltage divider.

4. The apparatus (100) of claim 3, wherein:

   the integer multiplier for each first capacitor of the MSWB signal line is four;
   the integer multiplier for each first capacitor of a second most significant weight bit signal line is two;
   the integer multiplier for each first capacitor of a third most significant weight bit signal line is one;
   wherein the MSWB signal line, the second most significant weight bit signal line and the third most significant weight bit signal line are coupled to each other with a short circuit and wherein:

      each signal line of lesser significance than the second most significant weight bit signal line is coupled to a signal line of one higher bit significance through at least one second capacitor, each second capacitor having a target capacitance of two times the unit capacitance; and
      each first capacitor of a signal line of lesser bit significance than the second most significant weight bit signal line has an integer multiplier of one; and
      a signal line of a least significant bit, LSB, is coupled to ground with at least one third capacitor, each third capacitor having a target capacitance equal to the unit capacitance.

5. The apparatus (100) of any preceding claim, wherein:

   the multiplication unit (204) of each bitcell (102, 200, 220) in a column in the bitcell array (101) representing a non-most significant bit, non-MSB, of a weight value is an AND gate;
   the multiplication unit (204) of each bitcell (102, 200, 220) in a column in the bitcell array (101) representing a most significant bit, MSB, of a weight value is a NAND gate.

6. The apparatus (100) of any preceding claim, wherein the apparatus further comprises:
   a sample-and-hold circuit (500) comprising at least one holding capacitor (502, 504), the at least one holding capacitor electrically couplable to sample a voltage at the output of the capacitor mesh circuit (104, 300, 350).

7. The apparatus (100) of claim 6, wherein the sample-and-hold circuit (500) comprises a first holding capacitor (502) and a second holding capacitor (504), the first holding capacitor (502) and the second holding capacitor (504) being electrically couplable to the output of the capacitor mesh circuit (104, 300, 350) to sample the voltage at the output of the capacitor mesh circuit (104, 300, 350) for each cycle of an input value of size N to obtain an analog MAC result.

8. The apparatus (100) of claim 7, wherein the sample-and-hold circuit further comprises:

   a first coupling switch (IA) electrically coupled between the first holding capacitor (502) and the output of the capacitor mesh circuit (104, 300, 350);
   a second coupling switch (IB) electrically coupled between the second holding capacitor (504) and the output of the capacitor mesh circuit (104, 300, 350);
   a first reset switch (RST_A) electrically coupled between the first holding capacitor (502) and ground;
   a second reset switch (RST_B) electrically coupled between the second holding capacitor (504) and ground; and
   a mesh reset switch (RST_$V_{mesh}$) electrically coupled between the output of the capacitor mesh circuit (104, 300, 350) and ground;
   wherein the apparatus (100) further comprises a sample and-hold control, SHCTRL, circuit configured to control the first coupling switch, the second coupling switch, the first reset switch, the second reset switch, and the mesh reset switch to obtain the analog MAC result.

9. The apparatus (100) of claim 8, wherein the apparatus further comprises an analog-to-digital converter, ADC, circuit, wherein the ADC circuit is configured to convert the analog MAC result to a digital MAC result, and the sample-and-hold circuit further comprises:

a first output switch (AO) electrically coupled between the first holding capacitor (502) and the ADC circuit; and a second output switch (BO) electrically coupled between the second holding capacitor (504) and the ADC circuit; wherein the SHCTRL circuit is further configured to control the first output switch and the second output switch to connect the first holding capacitor (502) and the second holding capacitor (504) the ADC circuit in an alternating fashion.

10. The apparatus (100) of claim 9, wherein the SHCTRL circuit is further configured to, by controlling the first coupling switch, the second coupling switch, the first reset switch, the second reset switch, the mesh reset switch, the first output switch, and the second output switch, to:

accumulate partial MAC results over a first plurality of input cycles to the first holding capacitor (502) as a first analog MAC result; accumulate partial MAC results over a second plurality of input cycles to the second holding capacitor (504) as a second analog MAC result; and during the second plurality of input cycles, provide the first MAC result to the ADC circuit.

11. The apparatus (100) of any preceding claim, further comprising a MAC Write Line, MACWL, decoder circuit, wherein the MACWL decoder circuit is configured to serially send input bits of the input value to the bitcell array (101) to be multiplied by the weight value.

12. The apparatus (100) of any preceding claim, further comprising:

an address decoder circuit configured obtain and address and to set a bitcell corresponding to the address to a Read and Write state; and a Read and Write, R/W, -circuit, configured to set or reset storage units of the bitcell corresponding to the address.

13. A method (900), comprising:

receiving (901) at least one weight value comprising M weight bits; storing (902) each weight value in the at least one weight value on a row of the bitcell array, wherein the weight value is distributed across M adjacent columns of bitcells as weight bits; receiving (904) an input value comprising N input bits; computing (903) an analog multiply-accumulate, MAC, result representing summed products of the input value and the at least one weight value, wherein the computing the analog MAC result comprises:

for each of N input cycles:

multiplying (907) an input bit of the input value by each weight bit of the weight value stored in the bitcell array; summing (908) a result of the multiplications of each weight bit position to a column position in a binary-weighted capacitive voltage divider circuit thus obtaining a partial MAC result at a most significant weight bit, MSWB, column position of the binary-weighted capacitive voltage divider circuit, wherein the partial MAC result comprises a sum of result of the multiplications of the MSWB column position and a binary-weighted sum of result of the multiplications of each non-MSWB column position; and storing (909) the partial MAC result to at least one holding capacitor of a sample-and-hold circuit; and

obtaining (920) the analog MAC result based on the partial MAC results over the N input cycle.

14. The method (900) of claim 13, wherein the computing the analog MAC result further comprises:

accumulating the partial MAC results over a first plurality of N input cycles to a first holding capacitor as a first analog MAC result; and

accumulating the partial MAC results over a second plurality of N input cycles to a second holding capacitor as a second analog MAC result and, during the second plurality of N input cycles, providing the first MAC result to an ADC.

15. A compute in memory, CIM, device (700) comprising at least one CIM module (704), wherein each CIM module in the at least one CIM module (704) comprises the apparatus (100) of any of claims 1 - 12, and the CIM device (700) further comprises a controller configured to perform the method (900) of any of claims 13 - 14 using the at least one CIM module (704).

FIG. 1

200

202

MAC-WL

WL

204

Q

Q(B)

WBL(B)

WBL

206

## FIG. 2A

220

202

MAC-WL

WL

206

Q

WBL(B)

WBL

204

## FIG. 2B

FIG. 3A

350

FIG. 3B

400

FIG. 4

500

RST_A

502

IA    AO

Vmesh

ADC

RST_Vmesh

IB    BO

RST_B

504

FIG. 5

FIG. 6

700

VDE 702

704  704    704  704    704  704    704  704

100

100

A1

A2

A3

706

708

FIG. 7

800

Data memory (DMEM) — 810

DMEM Arbiter 812

700

802

CIM Modules 100

Arithmetic Unit Array 706

VDE 702

VLSU 804

Processor 814

Control Unit (CU) 806

Programmable memory (PMEM) 808

FIG. 8

900

901

Receive at least one weight value

902

Store each weight value in the at least one weight value on a row of the bitcell array

904

Receive an input value comprising N in-put bits

903

907

Multiply an input bit of the input value by each weight bit of the weight value stored in the bitcell array

908

Sum a result of the multiplications of each weight bit position to a column position

909

Store the partial MAC result to at least one holding capacitor of a sample-and-hold circuit

920

Obtain the analog MAC result based on the partial MAC results over the N input cycle

FIG. 9

900

901

For each row of a bitcell array, receive a weight value comprising L weight bits.

902

For each weight bit, store the weight bit to a storage unit of a bitcell, wherein an entire weight value is distributed across L adjacent columns of bitcells.

904 — Receive an input value comprising N input bits.

905 — For each input bit of index i, starting from 0 (LSB), break at i=N-1

906 — Reset output of a capacitive voltage divider, CVD

i+1

903 —

907 — Multiply input bit i by each weight bit stored to the bitcell array

908 — Sum multiplication results of each weight bit position to a column position in the CVD

909 — Store output of the CVD to a holding capacitor in a S&H circuit.

910 — i=N-1    No

Yes

911 — Provide the result at the holding capacitor to an ADC

FIG. 10

Europäisches
Patentamt

European
Patent Office

Office européen
des brevets

# EUROPEAN SEARCH REPORT

**Application Number**

EP 25 15 1502

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 086 910 A1 (NOKIA TECHNOLOGIES OY [FI]) 9 November 2022 (2022-11-09) | 1-3,5-15 | INV. G06N3/065 |
| A | * figures 1-6,8-9 * | 4 | G11C11/54 H03M1/00 |
| A | US 7 812 757 B1 (WONG YAT TO WILLIAM [HK] ET AL) 12 October 2010 (2010-10-12) * column 3; figure 4 * | 4 | |
| A | ZANG QIBANG ET AL: "4b/4b/8b Precision Charge-Domain 8T-SRAM Based CiM for CNN Processing", 2023 IEEE 5TH INTERNATIONAL CONFERENCE ON ARTIFICIAL INTELLIGENCE CIRCUITS AND SYSTEMS (AICAS), IEEE, 11 June 2023 (2023-06-11), pages 1-5, XP034372188, DOI: 10.1109/AICAS57966.2023.10168593 [retrieved on 2023-07-07] * figures 2,3,5a * | 1-15 | |

**TECHNICAL FIELDS SEARCHED (IPC)**

G06N
G11C
H03M

The present search report has been drawn up for all claims

| Place of search | Date of completion of the search | Examiner |
|---|---|---|
| Munich | 21 May 2025 | Havard, Corinne |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 1502

This annex lists the patent family members relating to the patent documents cited in the above-mentioned European search report.
The members are as contained in the European Patent Office EDP file on
The European Patent Office is in no way liable for these particulars which are merely given for the purpose of information.

21-05-2025

| Patent document cited in search report | | Publication date | Patent family member(s) | | Publication date |
|---|---|---|---|---|---|
| EP 4086910 | A1 | 09-11-2022 | NONE | | |
| US 7812757 | B1 | 12-10-2010 | CN | 101807923 A | 18-08-2010 |
| | | | US | 7812757 B1 | 12-10-2010 |

For more details about this annex : see Official Journal of the European Patent Office, No. 12/82